# EUROPÄISCHE PATENTSCHRIFT

(11) **EP 1 966 892 B1**
(45) Veröffentlichungstag und Bekanntmachung des Hinweises auf die Patenterteilung: **29.04.2015**
(21) Anmeldenummer: 06807829.4
(22) Anmeldetag: 22.11.2006
(51) Int. Cl.: E05B 65/06

(54) **KRAFTFAHRZEUGTÜRGRIFF MIT SENSORANORDNUNG ZUM ERFASSEN DES ANDRÜCKENS EINES BEDIENERKÖRPERTEILS AN EINE SENSORFLÄCHE**
AUTOMOBILE DOOR HANDLE WITH SENSOR ARRANGEMENT FOR DETECTING THE PRESSING OF A USER BODY PART ON A SENSOR SURFACE
POIGNÉE DE PORTE POUR UN VÉHICULE AUTOMOBILE AVEC UN DISPOSITIF DETECTEUR SERVANT A LA DETECTION DE LA PRESSION EXERCEE PAR UNE PARTIE DU CORPS D'UN UTILISATEUR SUR UNE SURFACE DETECTRICE

(30) Priorität: 21.12.2005 DE 102005061754
(43) Veröffentlichungstag der Anmeldung: 10.09.2008
(73) Patentinhaber: Huf Hülsbeck & Fürst GmbH & Co. KG, 42551 Velbert (DE)
(72) Erfinder: SIMON, Jörg, 42489 Wülfrath (DE); WITTE, Martin, 48683 Ahaus (DE); MÖNIG, Stefan, 58332 Schwelm (DE)
(74) Vertreter: Zenz Patentanwälte Partnerschaft mbB
(86) Internationale Anmeldenummer: PCT/EP2006/068766
(87) Internationale Veröffentlichungsnummer: WO 2007/071516

(56) Entgegenhaltungen:
- WO-A-01/40607
- WO-A-2005/106163
- DE-A1- 10 131 896
- US-A- 3 274 828
- US-A- 3 878 477

## Beschreibung

Die Erfindung betrifft einen Kraftfahrzeugtürgriff mit Sensoranordnung zum Erfassen des Andrückens eines Bedienerkörperteils an eine Sensorfläche.

Dort erfasst sie eine Berührung oder ein Andrücken eines Bedienerkörperteils, beispielsweise einer Hand oder eines Fingers, um in Abhängigkeit davon eine Funktion, beispielsweise das Entriegeln oder das Verriegeln eines Türschlosses, auszulösen. Zum Auslösen einer Entriegelung oder einer Verriegelung sind nur kurzzeitige Ausgabeimpulse der Sensoranordnung erforderlich, die durch eine kurzzeitige Berührung mit der Hand bewirkt werden können. Zur Erfassung einer kurzzeitigen Berührung oder des Beginns einer Berührung eignen sich herkömmliche kapazitive Sensoren oder eine Kraft bzw. eine Verformung erfassende piezo-elektrische Sensoren. Kapazitive Sensoren haben den Nachteil, daß sie störanfällig gegenüber Änderungen von Umgebungseinflüssen (Verschmutzung oder Regen) oder Berührung durch fremde Objekte (Blätter, Zweige) sind. Diese Einflüsse führen zu Änderungen der vom Sensor erfaßten Kapazität, welche zu einer Fehlauslösung der entsprechenden Funktion führen können. Deshalb wurde beispielsweise in der Patentanmeldung DE 10 2004 019 571 bzw. WO 2005/106163 A1 vorgeschlagen, den eine Annäherung eines Bedienerkörperteils erfassenden kapazitiven Sensor mit einem mechanischen Hilfssensor zu kombinieren, wobei der mechanische Hilfssensor eine vom Bedienerkörperteil auf eine Betätigungsstelle ausgeübte Kraft mit Hilfe des piezo-elektrischen Effekts in einen kurzzeitigen elektrischen Impuls umwandelt. Der kurzzeitige elektrische Impuls wird in Kombination mit dem Ausgangssignal des kapazitiven Sensors ausgewertet. Dies gestattet eine höhere Sicherheit bei der Erfassung des Beginns einer Berührung der Betätigungsstelle. Die Dauer der Berührung wird nach wie vor aus dem Ausgangssignal des kapazitiven Sensors bestimmt.

Die WO 01/40607 A1 beschreibt einen Türgriff für ein Fahrzeug, bei welchem ein Sensor eine Verformung des Türgriffs erfasst, wobei der Sensor ein Piezoelement umfasst, das bei der Verformung des Türgriffs ebenfalls verformt wird und während des Verformens ein kurzzeitiges Signal erzeugt.

Die DE 10 131 896 A1 offenbart ebenfalls die Verwendung eines Piezoelements in einem Türgriff zu dem Zweck der Erfassung einer Verformung, wobei das Piezoelement zusätzlich zu einer Überwachung auf Spannungssignale hinsichtlich seiner Unversehrtheit überwacht wird.

Mit einem Sensor, der nicht nur eine kurzzeitige Berührung oder den Beginn einer längeren Berührung sicher erfassen kann, sondern der auch während der gesamten Dauer die Betätigung, das heißt die Berührung der Betätigungsstelle durch das Bedienerkörperteil, und die Wegnahme des Bedienerkörperteils sicher erfassen kann, ist es bei bekannten Türgriffanordnungen möglich, sogenannte Komfortfunktionen zu aktivieren. Beispielsweise bewirkt ein längeres Betätigen der Betätigungsstelle zum Auslösen des Verriegelns des Türschlosses gleichzeitig ein Hochfahren heruntergelassener Fensterscheiben, ein Zufahren eines Fahrzeugsverdecks und/oder ein Einklappen von Seitenspiegeln, wobei diese Funktionen gegebenenfalls dann unterbrochen werden sollen, wenn das Bedienerkörperteil von der Betätigungsstelle entfernt wird.

Bei der aus der genannten Patentanmeldung WO 2005/106163 A1 bekannten Sensoranordnung ist aber die exakte Erfassung der Wegnahme des Bedienerkörperteils nicht immer möglich. Es wurden daher Schaltungen und Verfahren vorgeschlagen, um mit Hilfe eines kapazitiven Sensors und eines mechanischen Hilfssensors ein sichereres Erfassen des Anliegens des Bedienerkörperteils während der gesamten Dauer der Betätigung zu ermöglichen. Beispielsweise schlägt die (unveröffentlichte) Patentanmeldung DE 10 2005 035 479.3 vor, daß eine Sensorauswerteschaltung dann, wenn das Ausgangssignal des mechanischen (piezo-elektrischen) Hilfssensors den Beginn des Aufliegens des Bedienerkörperteils anzeigt, ein etwa gleichzeitig vom kapazitiven Annäherungssensor ausgegebener Ausgangssignalwert als Referenzwert für die nachfolgende Auswertung von Änderungen des Annäherungssensorausgangssignals herangezogen wird, um ein Wegnehmen des Bedienersignals sicherer erfassen zu können.

Die US 3,878,477 offenbart eine Erfassungseinrichtung, welche akustische Oberflächenwellen auf Piezokristallen zur Detektion von Krafteinwirkungen nutzt.

Die US 3,274,828 befasst sich mit einem Kraftsensor zur Messung statischer Kräfte, der einen piezo-elektrischen Quarzoszillator enthält. Zur Kompensation von Störeinflüssen, wie beispielsweise der Temperatur, werden zwei identische hochgenaue Quarzoszillatoren betrieben, wovon auf den einen die zu messende Kraft einwirkt. Der schwingende Kristallbereich ist in einem Substrat in einem Bereich untergebracht, der weit genug von denjenigen Flächen entfernt ist, auf die die Kräfte einwirken, so dass die Schwingungen nicht mehr dort stattfinden, wo die Kräfte in das Substrat eingeleitet werden, so dass sie die Güte Q des schwingenden Resonators nicht beeinflussen, d.h., dass keine Dämpfung der Schwingung stattfindet. Die Krafteinwirkung führt zu einer Verformung (Kompression) des Kristalls, die sich im Ergebnis wie eine Änderung der mitschwingenden Masse auswirkt. Diese Kompression führt zu einer messbaren Verschiebung der Resonanzfrequenz des Quarzoszillators.

Nachteilig bei den bekannten Anordnungen ist der relativ hohe bauliche Aufwand.

Aufgabe der Erfindung ist es daher, einen Türgriff mit Sensoranordnung zum Erfassen des Andrückens eines Bedienerkörperteils an eine Sensorfläche zu schaffen, d auf einfache Weise eine sichere Erfassung des Andrückens während der gesamten Dauer ermöglicht.

Diese Aufgabe wird erfindungsgemäß durch einen Türgriff mit einer Sensoranordnung mit den Merkmalen des Anspruchs 1 gelöst. Der Erfindung liegt die Erkenntnis zugrunde, daß der piezo-elektrische Effekt als solcher für eine dauerhafte Erfassung des Andrückens eines Bedienerkörperteils ungeeignet ist, da das Ausgangssignal piezo-elektrischer Sensoren von der Änderung der Kraft abhängig ist und - insbesondere bei einer schwankenden Andruckkraft durch das Bedienerkörperteil - keine sichere Auswertung der Dauer des Aufliegens des Bedienerkörperteils zuläßt. Die Erfindung schlägt stattdessen vor, einen Piezo-Schwinger mit der Sensorfläche zu verbinden, in eine Oszillatorschaltung einzukoppeln und in Schwingungen zu versetzen, so daß eine Berührung oder ein Andrücken eines Bedienerkörperteils an die Sensorfläche zu einer Änderung des Schwingverhaltens (aufgrund der Dämpfung und der Erhöhung der mitschwingenden Masse) führt und diese Änderung mit Hilfe einer mit der Oszillatorschaltung gekoppelten Auswerteschaltung erfaßt werden kann. Die Änderung des Schwingverhaltens durch Berührung mit dem Bedienerkörperteil läßt sich relativ einfach und sicher auswerten, womit ein zeitlich unbegrenztes Betätigungssignal gewonnen werden kann.

Bei einer bevorzugten Ausführungsform ist der Piezo-Schwinger zwischen einer festen Auflage und einer Kunststoffolie oder Kunststoffschicht angeordnet, wobei die Oberseite der Kunststoffolie die Sensorfläche bildet. Über die Kunststoffolie oder Kunststoffschicht wird das aufliegende Bedienerkörperteil (zum Beispiel ein Finger) mit dem Piezo-Schwinger gekoppelt.

Eine vorteilhafte Weiterbildung der erfindungsgemäßen Sensoranordnung ist dadurch gekennzeichnet, daß zusätzlich ein Annäherungssensor vorgesehen ist, der die Annäherung des Körperteils an die Sensorfläche erfaßt und der mit einer Schaltung zum Aktivieren der Oszillatorschaltung derart gekoppelt ist, daß die Oszillatorschaltung nur dann aktiviert und der Piezo-Schwinger zum Schwingen veranlaßt wird, wenn sich ein Körperteil des Bedieners an die Sensorfläche annähert. Durch diese Weiterbildung ist eine erhebliche Reduktion des Energieverbrauchs der Sensoranordnung möglich.

Vorteilhafte und/oder bevorzugte Weiterbildungen der Erfindung sind in den Unteransprüchen gekennzeichnet.

Im folgenden wird die Erfindung anhand eines in der Zeichnung dargestellten bevorzugten Ausführungsbeispiels näher erläutert. In der Zeichnung zeigen:
Figur 1 eine schematische Längsschnittansicht durch einen Türgriff mit einem Ausführungsbeispiel der erfindungsgemäßen Sensoranordnung und
Figur 2 ein Blockschaltbild eines Ausführungsbeispiels der erfindungsgemäßen Sensoranordnung.

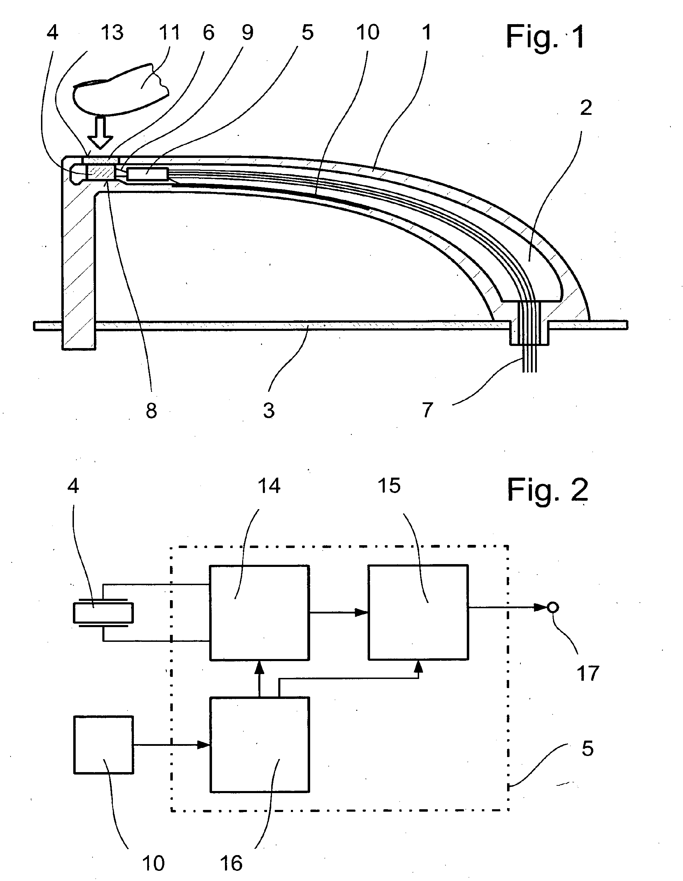

Figur 1 zeigt eine schematische Längsschnittansicht durch einen Kraftfahrzeug-Türgriff 1. Der Kraftfahrzeug-Türgriff 1 befindet sich beispielsweise an der Fahrer- oder Beifahrertür eines Kraftfahrzeugs. Er ist an einen (in Figur 1 nicht gezeigten) Träger montiert, der sich innerhalb der Tür, das heißt hinter einem Türblech 3 befindet. Der Türgriff 1 ist beispielsweise an einer Seite über ein Gelenk schwenkbar mit dem Träger verbunden und weist auf der anderen Seite einen das Türblech 3 durchgreifenden Arm auf, der das Türschloß mechanisch betätigt, wenn der Türgriff 1 geschwenkt wird.

Der in Figur 1 dargestellte Türgriff 1 weist in seinem Inneren einen Hohlraum 2 auf, in dem eine Steuerelektronik 5 angeordnet ist, die Bestandteil eines elektronischen Zugangssystems ist. Zuleitungen 7 zu der Steuerelektronik 5 verlaufen durch den Hohlraum 2 und eine Bohrung 8 innerhalb eines Teils des Türgriffs, der durch das Türblech 3 hindurchgeführt ist, und treten innerhalb der Tür aus dem Türgriff aus. Dort sind sie mit Anschlüssen für die Spannungsversorgung, die Masse und für Steuersignale verbunden.

Im Inneren des Türgriffs 1 können neben der Steuerelektronik Sensoren zum Erfassen einer Annäherung der Hand eines Bedieners, Sensoren zum Erfassen des Berührens einer Betätigungsstelle durch einen Finger des Bedieners und/oder Antennenanordnungen für eine drahtlose Kommunikation zwischen einer Steuereinrichtung des Kraftfahrzeugs und einem ID-Geber ("Schlüssel") des Bedieners sowie zugehörige Ansteuer- und Auswerteschaltungen enthalten sein. Zum Erfassen der Annäherung der Hand eines Bedieners weist der Türgriff 1 beispielsweise eine Elektrode 10 eines kapazitiven Sensors auf. Ein derartiger kapazitiver Sensor ist beispielsweise in der DE 196 17 038 A1 beschrieben. Diese Elektrode (es können auch mehrere Elektroden und zusätzliche Kompensationselektroden vorhanden sein) ist über Zuleitungen mit der Steuerelektronik 5 verbunden.

Gemäß Figur 1 enthält der Türgriff einen Piezo-Schwinger 4, der aus einem Piezo-Kristall mit aufgebrachten Elektroden besteht. Der Piezo-Schwinger 4 ist auf einer Auflage 8 befestigt (beispielsweise aufgeklebt). Auf einer entgegengesetzten Seite ist der Piezo-Schwinger 4 von einer dünnen Kunststoffolie oder Kunststoffwandung 6 überzogen, deren Oberseite die Sensorfläche 13 der Betätigungsstelle bildet. Der Piezo-Schwinger 4 ist über Zuleitungen 9 ebenfalls mit der Steuerelektronik 5 verbunden. Die Steuerelektronik 5 enthält eine Oszillatorschaltung, in die der Piezo-Schwinger eingekoppelt ist, so daß er zu Schwingungen angeregt wird (vorzugsweise bei seiner Resonanzfrequenz). Wenn ein Bedienerkörperteil, wie beispielsweise der Finger 11, auf die Sensorfläche 13 aufgelegt wird, so wird dieser Bedienerkörperteil 11 über die Kunststofffolie 6 mit dem Piezo-Schwinger derart gekoppelt, daß dessen Schwingverhalten beeinflußt wird. Beispielsweise sinkt die Resonanzfrequenz des Gesamtsystems durch die zusätzliche mitschwingende Masse. Außerdem erhöht sich die Dämpfung.

Figur 2 zeigt ein Blockschaltbild, das die Kopplung des Piezo-Schwingers 4 und der Elektrode 10 des kapazitiven Sensors mit denjenigen Elementen der Steuerelektronik 5 zeigt, die für die vorliegende Erfindung wesentlich sind. Der Piezo-Schwinger 4 ist in eine Oszillatorschaltung 14 eingekoppelt, welche den Piezo-Schwinger zu Schwingungen einer vorgegebenen Frequenz und Amplitude anregt. Die Oszillatorschaltung 14 ist mit einer Auswerteschaltung 15 derart gekoppelt, daß eine Änderung des Schwingverhaltens erfaßt und ein dies anzeigendes Ausgangssignal am Ausgangsanschluß 17 erzeugt werden kann. Beispielsweise überwacht die Auswerteschaltung 15 die Schwingfrequenz der Oszillatorschaltung 14 und/oder die Amplitude der Oszillatorschwingungen. Beispielsweise werden die Änderungen von das Schwingverhalten charakterisierenden Parametern (z. B. Frequenz, Periodendauer, Spannungen) mit vorgegebenen Schwellwerten verglichen, wobei ein Über- oder Unterschreiten eines oder mehrerer vorgegebener Schwellwerte als Anzeichen dafür gewertet wird, daß ein Bedienerkörperteil auf der Sensorfläche 13 aufliegt.

Die Elektrode 10 des kapazitiven Annäherungssensors ist mit einer Ansteuer- und Auswerteschaltung 16 verbunden, mit deren Hilfe die Elektrode 10 angesteuert und Kapazitätsänderungen ausgewertet werden. Außerdem dient die Schaltung 16 zum Aktivieren und Deaktivieren der Oszillatorschaltung in Abhängigkeit vom Ausgangssignal des kapazitiven Annäherungssensors. Wenn mit Hilfe des kapazitiven Annäherungssensors erfaßt wird, daß sich ein Bedienerkörperteil in der Nähe des Türgriffs 1 befindet, so wird die Oszillatorschaltung 14 aktiviert und der Piezo-Schwinger 4 zu Schwingungen angeregt. Gleichzeitig wird die Auswerteschaltung 15 von der Schaltung 16 aktiviert, so daß sie zum Erfassen des Aufliegens eines Bedienerkörperteils auf der Sensorfläche 13 zur Verfügung steht. Befindet sich dagegen kein Bedienerkörperteil in der Nähe des Türgriffs 1, so kann die Schaltung 16 die Oszillatorschaltung 14 und die Auswerteschaltung 15 deaktivieren, was den Energieverbrauch erheblich reduziert.

In Figur 1 ist als Elektrode 10 des kapazitiven Sensors eine an der Innenseite des Türgriffs 1 angeordnete Metallelektrode 10 dargestellt. Zusätzlich kann auch eine Elektrode eines weiteren kapazitiven Annäherungssensors in der Nähe oder an der Sensorfläche 13 angeordnet sein, die speziell zum Erfassen der Annäherung eines Bedienerkörperteils (Fingers) an die Sensorfläche 13 vorgesehen ist. Als Elektrode des kapazitiven Sensors kann auch eine der Elektroden des Piezo-Schwingers 4 dienen. Der Piezo-Schwinger 4 kann ein Biegeschwinger, Dickenschwinger und/oder Scherschwinger sein, wobei die Wahl der Schwingungsrichtung und der Anordnung der Elektroden in Abhängigkeit von den konstruktiven Gegebenheiten getroffen wird.

## Patentansprüche

1. Türgriff für ein Fahrzeug mit einer Sensoranordnung zum Erfassen des Andrückens eines Bedienerkörperteils (11) an eine Sensorfläche (13),
**dadurch gekennzeichnet, dass**
ein Piezo-Schwinger (4) in eine Oszillatorschaltung (14) eingekoppelt ist und in Schwingungen versetzt wird und derart mit der Sensorfläche (13) verbunden ist, dass eine Berührung oder ein Andrücken des Körperteils (11) an die Sensorfläche zu einer Änderung des Schwingverhaltens aufgrund der Dämpfung und der Erhöhung der mitschwingenden Masse führt, wobei der Piezo-Schwinger (4) in dem Türgriff (1) derart montiert ist, dass die Sensorfläche an einer Betätigungsstelle des Türgriffs angeordnet ist,
wobei die Oszillatorschaltung (14) mit einer Auswerteschaltung (15) derart gekoppelt ist, dass diese Änderung des Schwingverhaltens erfasst und ein dies anzeigendes Ausgangssignal (17) erzeugt werden kann.

2. Sensoranordnung nach Anspruch 1, **dadurch gekennzeichnet, dass** der Piezo-Schwinger (4) zwischen einer festen Auflage (8) und einer Kunststofffolie (6) angeordnet ist, wobei die Oberseite der Kunststofffolie (6) die Sensorfläche (13) bildet.

3. Sensoranordnung nach Anspruch 1 oder 2, **dadurch gekennzeichnet, dass** zusätzlich ein Annäherungssensor (10) vorgesehen ist, der die Annäherung des Körperteils (11) an die Sensorfläche (13) erfasst und der mit einer Schaltung (16) zum Aktivieren der Oszillatorschaltung (14) derart gekoppelt ist, dass die Oszillatorschaltung (14) dann aktiviert und der Piezo-Schwinger (4) zum Schwingen veranlaßt wird, wenn sich ein Körperteil des Bedieners an die Sensorfläche annähert.

## Claims

1. A door handle for a vehicle with a sensor arrangement for detecting the pressing of an operator body part (11) against a sensor surface (13),
**characterised in that**
a piezo oscillator (4) is coupled into an oscillator circuit (14) and is made to vibrate and is connected with the sensor surface (13) such that a touching or pressing of the body part (11) against the sensor surface leads to a change in oscillating behaviour due to the dampening of and increase in the oscillating mass, wherein the piezo oscillator (4) is mounted in the door handle (1) such that the sensor surface is arranged at an operating point of the door handle,
wherein the oscillator circuit (14) is connected with an evaluating circuit (15) such that this change in oscillating behaviour can be detected and an output signal (17) indicating this can be generated.

2. The sensor arrangement according to claim 1, **characterised in that** the piezo oscillator (4) is arranged between a firm support (8) and a plastic film (6), wherein the top of the plastic film (6) forms the sensor surface (13).

3. The sensor arrangement according to claim 1 or 2, **characterised in that** in addition a proximity sensor (10) is provided, which detects when the body part (11) approaches the sensor surface (13) and which is coupled with a circuit (16) for activating the oscillator circuit (14) such that the oscillator circuit (14) is activated and the piezo oscillator (4) is made to vibrate then, when a body part of the operator approaches the sensor surface.

## Revendications

1. Poignée de porte pour un véhicule avec un dispositif détecteur pour la détection de la pression d'une partie du corps d'un utilisateur (11) contre une surface de détection (13),
**caractérisée en ce que**
un oscillateur piézoélectrique (4) est intégré dans un circuit oscillateur (14) et qu'on le fait osciller et le relie à la surface détectrice (13) de manière à ce qu'un contact de la partie du corps (11) avec la surface détectrice, ou une pression contre celle-ci, produise une modification du comportement d'oscillation en raison de l'amortissement et de l'augmentation de la masse oscillant avec, l'oscillateur piézoélectrique (4) étant monté dans la poignée de porte (1) de manière à ce que la surface détectrice soit disposée à un emplacement d'actionnement de la poignée de porte,
le circuit oscillateur (14) étant couplé avec un circuit d'évaluation (15) de manière à ce que cette modification du comportement d'oscillation soit détectée et qu'un signal de sortie (17) indiquant cela puisse être généré.

2. Dispositif détecteur selon la revendication 1, **caractérisé en ce que** l'oscillateur piézoélectrique (4) est disposé entre un appui fixe (8) et une pellicule en matière synthétique (6), le dessus de la pellicule en matière synthétique (6) formant la surface détectrice (13).

3. Dispositif détecteur selon la revendication 1 ou 2, **caractérisé en ce que** l'on prévoit de manière supplémentaire un détecteur de proximité (10) qui détecte le rapprochement de la partie du corps (11) de la surface détectrice (13) et qui est couplé avec un circuit (16) pour l'activation du circuit oscillateur (14) de manière à ce que le circuit oscillateur (14) soit activé et que l'on fasse osciller l'oscillateur piézoélectrique (4) lorsqu'une partie du corps de l'utilisateur se rapproche de la surface détectrice.
